Europäisches Patentamt

European Patent Office

Office européen des brevets

(19)

(11) Veröffentlichungsnummer: **0 157 285**
**B1**

(12) **EUROPÄISCHE PATENTSCHRIFT**

(45) Veröffentlichungstag der Patentschrift: **27.06.90**

(51) Int. Cl.⁵: **H 05 K 5/06**

(21) Anmeldenummer: **85103182.3**

(22) Anmeldetag: **19.03.85**

(54) Geschlossenes Gehäuse zur Aufnahme elektrischer Bauteile.

(30) Priorität: **02.04.84 DE 3412274**

(43) Veröffentlichungstag der Anmeldung:
**09.10.85 Patentblatt 85/41**

(45) Bekanntmachung des Hinweises auf die
Patenterteilung:
**27.06.90 Patentblatt 90/26**

(84) Benannte Vertragsstaaten:
**BE DE GB LU NL**

(56) Entgegenhaltungen:
**WO-A-84/01082**
**DE-B-2 416 162**
**DE-B-2 852 113**
**DE-C- 971 154**
**DE-C-2 902 169**
**US-A-3 987 258**

(73) Patentinhaber: **ABB CEAG Licht- und**
**Stromversorgungstechnik GmbH**
**Senator-Schwarz-Ring 26**
**D-4770 Soest (DE)**

(72) Erfinder: **Neumann, Reinhard**
**Roseggerstrasse 3**
**D-4044 Kaarst 1 (DE)**
Erfinder: **Ploeger, Cornelius**
**Bonekamp 7**
**D-5758 Fröndenberg-Frömern (DE)**

(74) Vertreter: **Rupprecht, Klaus, Dipl.-Ing. et al**
**c/o CEAG Licht- und Stromversorgungstechnik**
**GmbH ZPT Postfach 100351**
**D-6800 Mannheim 1 (DE)**

Courier Press, Leamington Spa, England.

## Beschreibung

Die Erfindung betrifft ein geschlossenes explosionsgeschütztes Gehäuse zur Aufnahme elektrischer Bauteile, welches Gehäuse wenigstens eine Öffnung aufweist, die mittels einem pöröser, filterartiger aus gesintertem Material, Sinterkeramik oder Sinterkunststoff bestehender Verschlußstopfen verschlossen ist.

Explosionsgeschützte Langfeldleuchten und dergleichen besitzen ein Gehäuse, das zur Erzielung bestimmter Dichtigkeitsvorschriften bzw. Schutzarten allseitig verschlossen sein muß. Die Schutzart ist IP 65 nach IEC 529.

Bei derartigen Gehäusen ist nicht zu vermeiden, daß die wasserdampfenthaltende Umgebungsluft ins Innere des Gehäuses gelangt, und zwar aufgrund von durch Temperaturänderungen hervorgerufenen Atmungsvorgängen. Die im Inneren des Gehäuses befindliche Feuchtigkeit kann sich als Kondenswasser niederschlagen, was grundsätzlich vermieden werden muß.

Es gibt Lösungen, wonach die Langfeldleuchten nicht exakt horizontal, sondern schräg geneigt montiert werden, damit das Kondenswasser sich an einer bestimmten Stelle sammeln kann. An diesen Stellen sind Auslaß- oder Ablaufstutzen angeordnet, die in der Schutzart IP 44 ausgeführt sind.

Aus der DE-C-2 902 169 ist ein regen- und spritzwassergeschütztes Gehäuse bekannt geworden, das Belüfungsöffnungen am Boden aufweist, die in bestimmter Weise ausgebildet sind. Eine ähnliche Ausführung ist auch aus der DE-B-2 416 162 bekannt geworden. Diese Gehäuse sind zum Einsatz in explosionsgefährdeten Bereichen nicht geeignet.

Ein Gehäuse, das in explosionsgefährdeten Bereichen einsetzbar ist, ist aus der DE-B-2 852 113 bekannt geworden. Nicht zu verhindern ist hier, daß sich ins Innere des Gehäuses Kondenswasser bildet, weil zusätzlich zu den porösen Stopfen eine Berstscheibe vorgesehen ist.

Aus der US-A-3 987 258 ist ein wassergeschütztes Gehäuse für einen Lautsprecher beschrieben, bei dem unabhängig von atmosphärischen Verhältnissen eine gute Tonqualität erreicht werden soll. Zur Verhinderung des Eindringens von Wasser im Falle der Verwendung des Lautsprechers unter Wasser ist eine Öffnung vorgesehen, in die ein Filter eingesetzt ist, das aus zwischen 0,3 bis 5 mm dickem, aus zwei Schichten bestehenden Filtermaterial gebildet ist, wobei das Filter offensichtlich lediglich zum Schutz von einer Abdeckhaube abgedeckt ist. Das Filtermaterial soll absolut wasserdicht sein und lediglich Luft durchlassen.

Aus der WO 84/01082 ist eine Einrichtung zur Verhinderung von Kondensation im Inneren eines explosionsgeschützen Gehäuses bekannt geworden, bei der ein Stopfen aus porösem Material, vorzugsweise aus gesinteter Bronze oder Keramik mit einem dichten Balg verbunden ist; das poröse Material wird als Reduzierventil bei Explosionen im Gehäuse eingesetzt und der Balg dient zur Aufnahme von Druckschwankungen aufgrund von Änderung des atmosphärischen Druckes und der Temperatur. Kondensationsprobleme treten hierbei im Inneren des Gehäuses nicht auf. Sollte der Balg nicht vorgesehen werden, dann wird der Stopfen aus porösem Material als Dränageelement an der tiefsten Stelle des Gehäuses angeordnet und zwar in Form eines Bechers, in dem es sich sammeln kann; durch Druckerhöhungen im Inneren des Gehäuses wird es aus dem Gehäuse herausgedrückt wird.

Aufgabe der Erfindung ist es, ein Gehäuse der eingangs genannten Art zu schaffen, bei dem das Entstehen von Kondenswasser verhindert und das auch in explosions- oder schlagwettergefährdeten Bereichen einsetzbar ist.

Diese Aufgabe wird erfindungsgemäß dadurch gelöst, daß der Verschlußstopfen in einem in die Öffnung eingesetzten rohrartigen Stutzen eingesetzt ist, dessen außerhalb des Gehäuses befindlicher Rand mittels eines Deckelbodens mit wenigstens einer axial verlaufender Bohrung abgedeckt ist, daß an dem Stutzen annähernd in dessen mittlerem Bereich ein mit Radialbohrungen versehener Hohlzylinder angeschlossen ist, der den Stutzen teilweise übergreift und den mit dem Deckelboden verschlossenen Rand überragt, daß dieser Rand des Hohlzylinders von einer Abdeckhaube abgedeckt ist, und daß in der Bodenplatte der Abdeckhaube außerhalb des Hohlzylinders Bohrungen vorgesehen sind. Als Material für den Verschlußstopfen können Filtermaterial, z.B. aus Kunststoff, Kohle, Mineralien etc., gesintertes Material wie z.B. Sinterbronze, Sinterkeramik oder Sinterkunsstoff verwendet werden, welche ausreichende Festigkeit aufweisen.

Weitere vorteilhafte Ausgestaltungen der Erfindung sind den weiteren Unteransprüchen zu entnehmen.

Mit der erfindungsgemäßen Ausführung wird ein Belüftungssystem gebildet, mit dem die Schutzart IP 65 sichergestellt ist und mit dem ein kontinuierlicher Belüftungsstrom durch das Innere des Gehäuses bewirkt wird. Das Belüftungssystem kann dabei wahlweise in das Gehäuse eingeklebt bzw. eingeschraubt werden; insbesondere kann der Rohrstutzen in das Gehäuse eingeschraubt werden. Im Prinzip würde eine einzige Öffnung genügen; eine optimale Belüftung und eine optimale Luftzirkulation aber kann praktisch nur mit zwei oder mehr erfindungsgemäß ausgebildeten Öffnungen erzielt werden. Die Erfindung kann nicht nur bei Ex-Langfeldleuchten angewandt werden, sondern überall dort, wo in geschlossenen Gehäusen, die der Schutzart IP 65 genügen, Kondenswasserbildung zu befürchten ist. Dies kann außer bei Ex-Langfeldleuchten auch bei anderen Gehäusen, wie z.B. Abzweigdosen- und dergleichen der Fall sein.

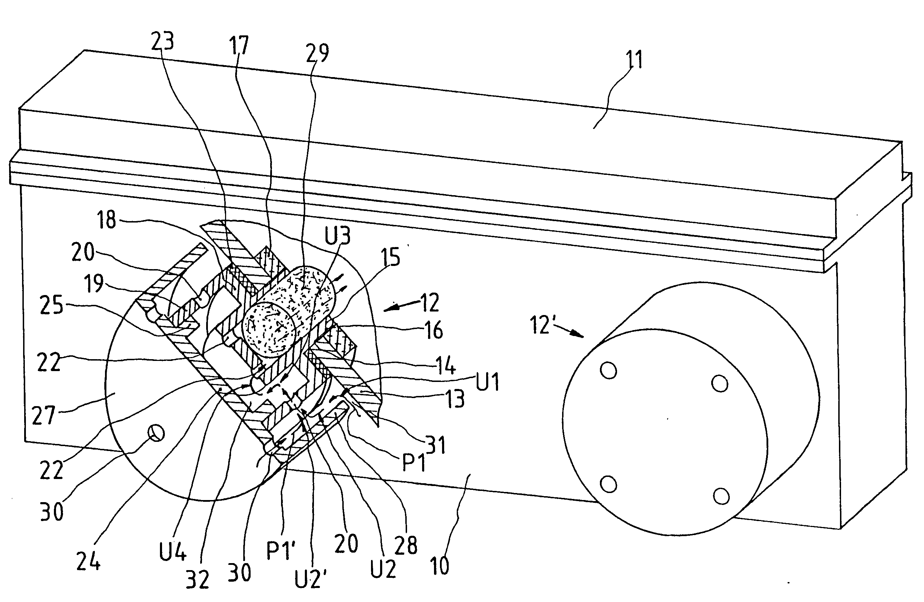

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigt:

die einzige Figur eine perspektivische Ansicht eines Gehäuses zur Aufnahme elektrischer Bauteile, wobei einer der Belüftungsöffnungen im Schnitt dargestellt ist.

Das Gehäuse besitzt ein Gehäuseunterteil 10, das mittels einer Schutzhaube 11, die aus transparentem Material gebildet sein kann, abgedeckt ist. In dem Gehäuseunterteil 10 sind zwei Belüftungssysteme, die in ihrer Gesamtheit mit der Bezugsziffer 12 und 12' bezeichnet sind, eingesetzt. Die Erfindung die sich auf die Ausgestaltung dieser Systeme bezieht, soll anhand des Systems 12 näher erlautert und beschrieben werden. In der einzigen Figur erkennt man demgemäß eine perspektivische, geschnittene Darstellung eines Systems.

Das Gehäuseunterteil 10 ist durch eine Gehäusewand 13 gebildet, in die eine Bohrung 14 eingebracht ist. Diese Bohrung 14 wird von einem rohrförmigen Stutzen 15 durchdrungen, der in seinem äußeren Bereich einen Gewindeabschnitt 16 aufweist, auf den eine mit Innengewinde versehene Befestigungsmutter 17 aufgeschraubt ist. Die Befestigungsmutter kann auch aufgeklebt sein.

Annähernd im mittleren Bereich besitzt der Rohrstutzen einen radial vorspringenden Kragen 18, an dessen Außenumfang ein Hohlzylinder 19 angeformt ist, dessen Innendurchmesser deutlich größer ist, als der Außendurchmesser des Stutzens 15. In dem Hohlzylinder 19 sind radial verlaufende Bohrungen 20 vorgesehen.

An dem dem Gewindebereich 16 gegenüberliegenden Ende des Stutzens 15 ist dieser mittels eines Deckels 21 abgeschlossen, der von zwei Bohrungen 22 durchsetzt ist. Der Deckel 21 ist, wie aus der Figur ersichtlich, an dem Rohrstutzen angeformt und bildet mit diesem einen Teil.

Nach außen wird der Hohlzylinder 19 von einer Abdeckhaube 24 abgedeckt, die einen ersten Zylinderring 25 an einer Seite aufweist, mit dem sie in den Hohlzylinder 19 eingesetzt, z.B. eingeklebt und darin befestigt ist. Am Außenumfang 26 des Bodens 27 der Abdeckhaube 24 ist ein zweiter Zylinderring 28 angeformt, der den ersten Zylinderring 25 deutlich überragt und der in Abstand zu diesem angeordnet ist.

In das Innere des Rohrstutzens 15 ist ein poröser Verschlußstopfen 29 eingesetzt, vorzugsweise eingeklebt, in jedem Falle darin befestigt. Der Bodenteil 27 der Abdeckhaube besitzt Bohrungen 30, die im Bereich zwischen dem ersten und dem zweiten Zylinderring angebracht bzw. vorgesehen sind.

Die Montage der Gesamtanordnung verläuft wie folgt:

Zunächst wird der Verschlußstopfen 29 in das Innere des Stutzens 15 eingesetzt und darin befestigt. Sodann wird die Abdeckhaube auf den Hohlzylinder 19 aufgesetzt; aufgrund der Länge des Hohlzylinders 19, der den Stutzen deutlich überragt, befindet sich die Abdeckhaube bzw. das Bodenteil der Abdeckhaube im Abstand zum Deckel 21.

Sodann wird über den Bereich des Stutzens 15, der das Gewindeteil 16 aufweist, eine aus Weichgummi hergestellte Dichtung 23 gesetzt, und zwar soweit, bis die Dichtung an dem radialen Kragen 18 anliegt. Danach wird der Stutzen 15 durch die Bohrung 14 im Gehäuse 10 bzw. in der Gehäusewand 13 hindurchgesteckt und auf den Stutzen 15 im Inneren des Gehäuses 10 die Mutter 17 aufgeschraubt, wodurch der rohrförmige Stutzen an der Gehäusewand 13 befestigt wird. Wenn der Stutzen 15 eingeklebt ist, kann die Dichtung 23 entfallen. Aufgrund der erfindungsgemäßen Ausgestaltung endet der freie Rand des zweiten Zylinderringes 28 in Abstand zu der Außenfläche zu der Gehäusewand 13. Dadurch wird ein labyrinthartiger Weg für die in das Innere des Gehäuses eindringende Luft erzeugt: Die Luft kann durch den zwischen dem freien Ende des zweiten Zylinderringes 28 und der Gehäuseaußenfläche gebildeten Spalt 31 in Pfeilrichtung P1 eindringen, strömt dann durch die Bohrungen 20 in den zwischen der Außenfläche des Stutzens 15 und dem Hohlzylinder 19 und der Außenfläche des Deckels 21 und der Innenfläche des Bodenteils 27 der Abdeckhaube gebildeten Raum 32 und von dort über die Öffnungen 22 durch den porösen Verschlußstopfen 29 hindurch nach innen ins Innere des Gehäuses. Diese einströmende Luft kann an der anderen Öffnung bei 12 in der gleichen Weise wieder herausströmen. Zusätzlich kann auch Luft gemäß Pfeilrichtung P1' durch die Bohrungen 30 in den Raum zwischen der Außenfläche des Hohlzylinders 19 und der Innenfläche des zweiten Zylinderringes 28 eindringen und strömt dann in gleicher Weise weiter wie die gemäß Pfeilrichtung einströmende Luft. Man erkennt, daß die Luft bei der Strömung gemäß Pfeilrichtung P1 vier Umlenkungen aufgezwungen bekommt: eine Umlenkung $U_1$ um 90°, eine weitere Umlenkung $U_2$ ebenfalls um 90°, eine dritte Umlenkung $U_3$ wiederum um 90° und eine vierte Umlenkung $U_4$ 180°. Bei der Luftströmung gemäß Pfeilrichtung P1' erhält man lediglich eine Umlenkung um 90° $U2'$. Mit der erfindungsgemäßen Ausführung können Ex-Langfeldleuchten und andere Gehäuse, die den Vorschriften IP 65 zu genügen haben, schon von vorne herein oder auch nachträglich ausgerüstet werden. Es hat sich herausgestellt, daß beim Vorsehen zweier Systeme 12 und 12' eine optimale Luftzirkulation im Inneren des Gehäuses stattfindet, wodurch Kondenswasserbildung im Inneren des Gehäuses praktisch vermieden wird.

## Patentansprüche

1. Geschlossenes explosionsgeschütztes Gehäuse (10, 11) zur Aufnahme elektrischer Bauteile, welches Gehäuse wenigstens eine Öffnung (14) aufweist, die mittels einem poröser, filterartiger aus gesintertem Material, Sinterkeramik oder Sinterkunststoff bestehender Verschlußstopfen (29) verschlossen ist, dadurch gekennzeichnet, daß der Verschlußstopfen (29) in einem in die Öffnung (14) eingesetzten rohrartigen Stutzen (15) eingesetzt ist, dessen außerhalb des Gehäuses (10) befindlicher Rand mittels eines Deckelbodens (21) mit wenigstens einer axial verlaufenden Bohrung (22) abgedeckt ist, daß an dem Stutzen (15) annähernd in dessen mittlerem Bereich ein mit Radialbohrungen (20) versehener Hohlzylinder (19) angeschlossen ist, der den Stutzen teilweise übergreift und den mit dem Deckelboden (21) verschlossenen Rand überragt, daß dieser Rand des Hohlzylinders (19) von einer Abdeckhaube (24) abgedeckt ist, und daß in der Bodenplatte (27) der Abdeckhaube außerhalb des Hohlzylinders Bohrungen (30) vorgesehen sind.

2. Gehäuse nach Anspruch 1, dadurch gekennzeichnet, daß der Hohlzylinder (19) über einen radial verlaufenden Flanschkragen (18) mit dem Stutzen (15) einstückig verbunden ist.

3. Gehäuse nach einem der vorigen Ansprüche, dadurch gekennzeichnet, daß der Hohlzylinder (19) einen an der Abdeckhaube angeformten ersten Zylinderring (25) umfaßt, bzw. von diesem umfaßt ist und mit diesem fest verbunden ist.

4. Gehäuse nach einem der vorigen Ansprüche, dadurch gekennzeichnet, daß an dem Außenumfang der Abdeckhaube (24) an der den ersten Zylinderring (25) tragenden Seite ein zweiter Zylinderring (28) angeformt ist, dessen freier Endrand im montierten Zustand im Abstand vor der Außenfläche des Gehäuses (13) liegt.

5. Gehäuse nach einem der vorigen Ansprüche, dadurch gekennzeichnet, daß der rohrförmige Stutzen (15) mit darin eingesetztem Verschlußstopfen (29) und auf den Hohlzylinder (19) aufgesetzter Abdeckhaube in die Öffnung (14) in die Gehäusewand (13) eingesetzt und an dieser Gehäusewand (13) festgeschraubt ist.

6. Gehäuse nach Ansprüche 5, dadurch gekennzeichnet, daß zwei Öffnungen (14) in Abstand zueinander vorgesehen sind.

**Revendications**

1. Boîtier fermé et antidéflagrant (10, 11) prévu pour le logement de composants électriques, ledit boîtier présentant au moins une ouverture (14) qui est fermée au moyen d'un bouchon de fermeture (29) poreux, du genre filtre, et constitué par un matériau fritté, une céramique frittée ou une matière synthétique frittée, caractérisé en ce que le bouchon de fermeture (29) est inséré dans un manchon tubulaire (15) qui est introduit dans l'ouverture (14) et dont l'extrémité se trouvant à l'extérieur du boîtier (10) est couverte au moyen d'un fond-couvercle (21) présentant au moins un trou s'étendant axialement (22), en ce que, sur le manchon (15), approximativement dans sa zone médiane, est raccordé un cylindre creux (19) qui est pourvu de trous radiaux (20) et qui entoure partiellement le manchon et dépasse l'extrémité fermée par le fond-couvercle (21), en ce que cette extrémité du cylindre creux (19) est recouverte d'un capuchon (24) et en ce que des trous (30) sont prévus à l'extérieur du cylindre creux, dans la plaque de fond (27) du capuchon.

2. Boîtier suivant la revendication 1, caractérisé en ce que le cylindre creux (19) est raccordé en une pièce au manchon (15), par un collet (18) qui s'étend radialement.

3. Boîtier suivant l'une ou l'autre des revendications précédentes, caractérisé en ce que le cylindre creux (19) entoure une première bague cylindrique (25) formée sur le capuchon ou est entouré par cette dernière et en ce qu'il est raccordé de manière fixe à cette dernière.

4. Boîtier suivant l'une quelconque des revendications précédentes caractérisé en ce que, sur le pourtour externe du capuchon (24) et du côté portant la première bague cylindrique (25), est formée une seconde bague cylindrique (28) dont le bord d'extrémité libre se situe, à l'état monté, à une certaine distance devant la surface externe du boîtier (13).

5. Boîtier suivant l'une quelconque des revendications précédentes, caractérisé en ce que le manchon tubulaire (15) est, avec le bouchon de fermeture (29) qui y est inséré et avec le capuchon qui est mis sur le cylindre creux (19), introduit dans l'ouverture (14) de la paroi du boîtier (13) et en ce qu'il est vissé à bloc sur cette paroi du boîtier (13).

6. Boîtier suivant la revendication 5, caractérisé en ce que deux ouvertures (14) sont prévues à distance l'une de l'autre.

**Claims**

1. Closed explosion-protected housing (10, 11) for accommodating electric components, which housing exhibits at least one opening (14) which is closed by means of a porous filter-like closing plug (29) consisting of sintered material, sintered ceramics or sintered plastics, characterized in that the closing plug (29) is inserted in a tubular stub (15) inserted in the opening (14), the edge of which stub, located outside the housing (10), is covered by means of a cover bottom (21) having at least one axial hole (22), that at the stub (15), approximately in its centre area, a hollow cylinder (19) provided with radial holes (20) is connected which partially reaches over the stub and projects over the edge closed with the cover bottom (21), that this edge of the hollow cylinder (19) is covered by a covering hood (24), and that holes (30) are provided in the bottom plate (27) of the covering hood outside the hollow cylinder.

2. Housing according to Claim 1, characterized in that the hollow cylinder (19) is integrally connected to the stub (15) via a radial flange collar (18).

3. Housing according to one of the preceding claims, characterized in that the hollow cylinder (19) encloses a first cylindrical ring (25) which is moulded on the covering hood, or is enclosed by this ring, and is permanently joined to it.

4. Housing according to one of the preceding claims, characterized in that on the outer circumference of the covering hood (24), on the side carrying the first cylindrical ring (25), a second cylindrical ring (28) is moulded on, the free end edge of which is located at a distance in front of the outside surface of the housing (13) in the assembled state.

5. Housing according to one of the preceding claims, characterized in that the tubular stub (15), with the closing plug (29) inserted therein and the covering hood placed onto the hollow cylinder (19), is inserted into the opening (14) in the housing wall (13) and is screwed tight against this housing wall (13).

6. Housing according to Claim 5, characterized in that two openings (14) are provided at a distance from one another.